# EUROPEAN PATENT APPLICATION

(11) **EP 3 742 563 A1**
(43) Date of publication of application: **25.11.2020**
(21) Application number: 19175998.4
(22) Date of filing: 22.05.2019
(51) Int. Cl.: H01S 5/06, H01S 5/183, H01S 5/42, H01S 5/062, H01S 5/065, H01S 5/0683

(54) **VERTICAL CAVITY SURFACE EMITTING LASER DEVICE, LASER LIGHT SOURCE AND METHOD OF OPERATING A LASER LIGHT SOURCE**

(71) Applicant: TRUMPF Photonic Components GmbH, 89081 Ulm (DE)
(72) Inventor: The designation of the inventor has not yet been filed
(74) Representative: Witte, Weller & Partner Patentanwälte mbB

(57) **Abstract**

A Vertical Cavity Surface Emitting Laser (VCSEL) device (10) comprises a one- or two-dimensional array of Vertical Cavity Surface Emitting Lasers (12, 14, 16, 18), each of the Vertical Cavity Surface Emitting Lasers (12, 14, 16, 18) comprising a first distributed Bragg reflector layer structure (22), a second distributed Bragg reflector layer structure (26) and an active region layer structure (24) arranged between the first and second distributed Bragg reflector layer structures (22, 26) for laser emission, a first electrical contact (28) and a second electrical contact (30) arranged to provide a current path between the first and second electrical contacts (28, 30) to provide a drive current to the active region layer structure (24), a phototransistor layer structure (32), wherein the phototransistor layer structure (32) is arranged such that there is an optical coupling between the active region layer structure (24) and the phototransistor layer structure (32) to provide an optically controlled first current aperture in the current path during operation of the Vertical Cavity Surface Emitting Laser (12, 14, 16, 18), a current confinement layer structure (42) configured to provide a geometrically fixed second current aperture (46) in the current path in addition to the optically controlled first current aperture. The first electrical contacts (28) of the VCSELs are electrically connected in parallel so that the VCSELs may be drive in parallel.

## Description

### FIELD OF THE INVENTION

The present invention relates to a Vertical Cavity Surface Emitting Laser (VCSEL) device comprising a monolithically integrated photo transistor. The invention further relates to a light source having such a VCSEL device. The invention still further relates to a method of operating a laser light source.

### BACKGROUND OF THE INVENTION

US 2012/0128020 A1 discloses to integrate a photo transistor layer structure into the layer stack of a Vertical Cavity Surface Emitting Laser (VCSEL). Such VCSELs are also referred to as TRACSELs (transistor-confined surface-emitting lasers). By configuration of the phototransistor as optical switch, the current path through the device may be defined optically in a TRACSEL. In TRACSELs of the prior art, the phototransistor replaces the oxide aperture commonly used in VCSELs for current confinement.

In a configuration of an array of parallel-driven TRACSELs it has been observed that the current aperture, after the optically controlled opening by the photo transistors of the individual TRACSELs, is relatively wide and the laser thresholds are comparatively high, in particular for large area arrays.

Further, it would be desirable to provide a TRACSEL array with increased operating life-time of the whole laser device. Such a VCSEL device or light source may be advantageous in applications where repairing is not possible or only possible with high technical expenditure due to external circumstances like in satellites.

### SUMMARY OF THE INVENTION

It is an object of the present invention to provide a VCSEL device with increased operating life-time.

It is a further object of the present invention to provide a laser light source with increased operating life-time.

It is a still further object of the present invention to provide a method of operating a laser light source.

According to a first aspect, a Vertical Cavity Surface Emitting Laser (VCSEL) device is provided. The VCSEL device comprises a one- or two-dimensional array of VCSELs. Each VCSEL comprises a first distributed Bragg reflector (DBR) layer structure, a second DBR layer structure and an active region layer structure arranged between the first and second DBR layer structures for laser emission. Each VCSEL comprises a first electrical contact and a second electrical contact arranged to provide a current path between the first and second electrical contacts to provide a drive current to the active region layer structure. Each VCSEL further comprises a phototransistor (PT) layer structure, wherein the PT layer structure is arranged such that there is an optical coupling between the active region layer structure and the PT layer structure to provide an optically controlled first current aperture in the current path during operating of the respective VCSEL. Each VCSEL further comprises a current confinement layer structure configured to provide a geometrically fixed second current aperture in the current path in addition to the optically controlled first current aperture. The first electrical contacts of the VCSELs are electrically connected in parallel so that the VCSELs of the array may be driven in parallel.

The VCSELs of the array comprise a hybrid design with an integrated phototransistor and, in addition thereto, a current confinement layer. Thus, the VCSELs are TRACSELs with optically controlled current apertures and geometrically fixed current apertures in combination with one another.

The hybrid design has the advantage that the geometrically fixed second current aperture of each TRACSEL provides for low laser threshold currents and an optical guiding of the laser mode. The integrated PT has the function of a "decision unit" in the sense that always only one TRACSEL in the array is active, i.e. is in lasing operation. This is in contrast to standard current-confined VCSEL arrays without PT, where all VCSELs of the array are active at the same time. The present invention combines the advantages of an optically controlled current confinement by the integrated PTs and an active current confinement by the geometrically fixed current apertures in the current path.

Upon a breakdown of the active TRACSEL, the current flow is automatically diverted to another TRACSEL in the array. Thus, in dependence on the number of TRACSELs in the array, the operating life-time of the whole VCSEL device may be increased.

The VCSELs of the array may be driven in parallel. To this end, the first electrical contacts are electrically connected in parallel with one another. The first electrical contacts may be the anodes of the VCSELs.

The VCSELs may be arranged in a single line (one-dimensional array) or in several lines (columns and rows) or other two-dimensional geometries to provide a two-dimensional array.

The array may comprise two, three, four or a multitude of VCSELs.

In a further embodiment, at least one of the first distributed Bragg reflector layer structure, the second distributed Bragg reflector layer structure, the active region layer structure, the phototransistor layer structure, or the current confinement layer structure is a layer structure commonly shared by the VCSELs of the array. Preferentially, more than one of the afore-mentioned layer structures are commonly shared by the VCSELs of the array. In a particular preferred embodiment, all of the afore-mentioned layer structures may be commonly shared by the VCSELs of the array.

Each VCSEL defines a light emission region of the array, and adjacent light emission regions may be connected by a ridge comprising at least one of the afore-mentioned commonly shared layer structures. The ridge may preferentially comprise more than one of the afore-mentioned commonly shared layer structures, or further preferentially all of the afore-mentioned commonly shared layer structures.

In conventional TRACSEL arrays having a structure of single mesas (TRACSELs) pairwise connected by a respective ridge built-up by the semiconductor layer stacks of the individual TRACSELs, the areas below the ridges become successively conductive so that finally a large current aperture arises and the laser threshold can not be reached any more. In contrast thereto, the current confinement layer structure of each of individual VCSELs (mesas) as provided by the present invention prevents the generation of a large current aperture or, in other words, that the areas below the ridges become current conducting. Thus, the laser threshold does not increase in the VCSEL device according to the invention since there is no widening up of the current aperture when ramping up the drive current.

In a further embodiment, the phototransistor layer structure may be a distributed bipolar phototransistor (PT) layer structure. Such a distributed bipolar phototransistor layer structure may comprise a collector layer structure, a light sensitive layer structure, a base layer structure and an emitter layer structure. The distributed bipolar phototransistor layer structure may be a distributed heterojunction bipolar phototransistor layer structure.

The current confinement layer structure may comprise a current-blocking region and a current transmitting region to provide the second current aperture in the current path between the first and second electrical contacts of each VCSEL. The current-blocking region may be an oxidized region of a semiconductor layer. In this embodiment, the geometrically fixed second current aperture may be referred to as an oxide aperture. The current-blocking region may also be made by other isolating materials in other embodiments.

The phototransistor layer structure and the current confinement layer structure may be arranged adjacent to one another or adjacent to the active layer region structure in direction perpendicular the planes of the PT and current confinement layer structures. In particular, the PT layer structure or the current confinement layer structure may be arranged adjacent to the active region layer in direction perpendicular the active region layer structure. The arrangement of the PT layer structure close to the active region of each VCSEL may enable an efficient carrier confinement by optically controlling the carrier injection as a function of the local intensity of the actual profile of the lasing mode. The phototransistor layer structure may be arranged immediately above or below the active region layer structure. Similarly, the current confinement layer structure may be arranged immediately above or below the active region layer structure. In other embodiments, the phototransistor layer structure and/or the current confinement layer structure may be integrated into one of the first or second distributed Bragg reflector layer structures.

According to a second aspect, a laser light source is provided, comprising a vertical cavity surface emitting laser device according to the first aspect and a power source to provide a drive current to the array of Vertical Cavity Surface Emitting Lasers.

Such a light source is characterized by an increased life-time. The life-time of the light source may be estimated as the life-time of a single TRACSEL multiplied with the number of TRACSELs comprised in the array.

It shall be understood that the laser light source according to the second aspect may have similar and/or identical embodiments as the VCSEL device according to the first aspect.

The laser light source preferentially comprises a drive current control configured to reduce or interrupt the drive current supply by the power source to the array upon a breakdown of laser emission of the array and then to increase the drive current again. This configuration ensures immediate laser emission of an other TRACSEL after breakdown of the previously active TRACSEL. It is sufficient to interrupt the drive current for a short time period and the drive current may be immediately thereafter increased again so that only one TRACSEL becomes active after the breakdown of the previously active TRACSEL.

The laser light source may further comprise a laser emission output detector configured to detect a breakdown of laser emission of the array. The drive current control may use the signal of the laser emission output detector in order to reduce or interrupt the drive current supply to the array upon a breakdown of laser emission of the array. The laser emission output detector may be realized by a simple optical detector like a photodiode which may be a photodiode integrated into the array of VCSELs or external to the array. The laser emission output detector may also be configured as a voltage detector. Upon breakdown of the laser light emitting TRACSEL, the operating voltage increases temporarily, and this temporary voltage increase may be easily detected.

Since only one TRACSEL actively emits laser light at the same time, and since an other TRACSEL immediately emits laser light upon breakdown of the previously actively laser light emitting TRACSEL, an almost constant output power of the array may be ensured, modulo lateral ohmic losses in the array.

The power source may be electrically connected to one of the first contacts. In this configuration, a drive current is injected into one of the VCSELs. The position of the VCSEL in the array into which the drive current is injected determines which of the TRACSELs starts lasing first. The TRACSEL which starts lasing first is not necessarily the VCSEL into which the drive current is injected. The switching-on behavior of the single VCSELs in the array depends on optical and electrical influences prevailing in the array. For example, assuming that the drive current is injected into a VCSEL positioned at a lateral end of the array, the electrical losses increase towards the opposite side. Then, it is a matter of the imbalance between optical and electrical influences which influence the switching-on sequence. The optical influences arise from the superimposition of intensities of spontaneous emission within the optical resonators in the single VCSELs. For low lateral ohmic losses, it is to be expected that initially a VCSEL which is arranged centrally in the array will switch on first as the optical intensity is highest in the center portion of the array. For identical intensity in a symmetrical array, then the lateral ohmic losses decide on the further generation of current apertures.

In an embodiment, the one first contact into which the drive current is injected may be arranged at the lateral end of the array.

According to a third aspect, a method of operating a laser light source according to the second aspect is provided. The method comprises providing a drive current to the array of VCSELs. The method further comprises increasing the drive current such that only one of the VCSELs of the array emits laser light and all other VCSELs of the array do not emit laser light. The method further comprises monitoring the laser emission.

The method may further comprise decreasing the drive current when the monitoring of the laser emission reveals a breakdown of the laser emission, then increasing again the drive current, until an other VCSEL of the array emits laser light, and all other VCSELs of the array do not emit laser light.

A VCSEL device according to the invention, a light source comprising such a VCSEL device according to the invention, and/or a method of operating a light source comprising a VCSEL device according to the invention may be advantageous in apparatuses in which the VCSELs are fixedly integrated and repair of the VCSEL device would represent a considerable expenditure, or which are used in applications where repair due to environmental circumstances is not possible, for example in satellites.

The operating life-time of the light source comprising the VCSEL device according to the invention can be largely increased depending on the number of VCSELs used in the array. The life-time of the VCSEL device according to the invention or of a light source comprising the VCSEL device may thus be increased by a factor corresponding to the number of VCSELs in the array, since only one of the VCSELs actively emits laser light at the same time.

According to a fourth aspect, a computer program comprising program code means for causing a laser light source according to the second aspect to carry out the steps of the method according to the third aspect when said computer program is carried out on a processor of the light source according to the second aspect.

It shall be understood that a preferred embodiment of the invention can also be any combination of the dependent claims with the respective independent claim.

Further advantageous embodiments are defined below.

### BRIEF DESCRIPTION OF THE DRAWINGS

These and other aspects of the invention will be apparent from and elucidated with reference to the embodiments described hereinafter. In the following drawings
Fig. 1 shows a VCSEL device comprising an array of VCSELs with integrated phototransistor layer structure and current confinement layer structure;
Fig. 2 shows a sketch of a laser light source comprising a VCSEL device according to Fig. 1;
Fig. 3 shows four sketches of the switching-on behavior of a light source comprising a VCSEL device with four VCSELs with integrated phototransistor, but without current confinement layer structure according to the prior art;
Fig. 4 shows four sketches of the switching-on behavior of a light source comprising a VCSEL device with four VCSELs with integrated PT and current confinement layer structure according to the invention;
Fig. 5 shows four diagrams of simulated light intensities in a VCSEL device according to Fig. 1; and
Fig. 6 shows a sketch of a method of operating the VCSEL device in Fig. 1.

### DETAILED DESCRIPTION OF THE INVENTION

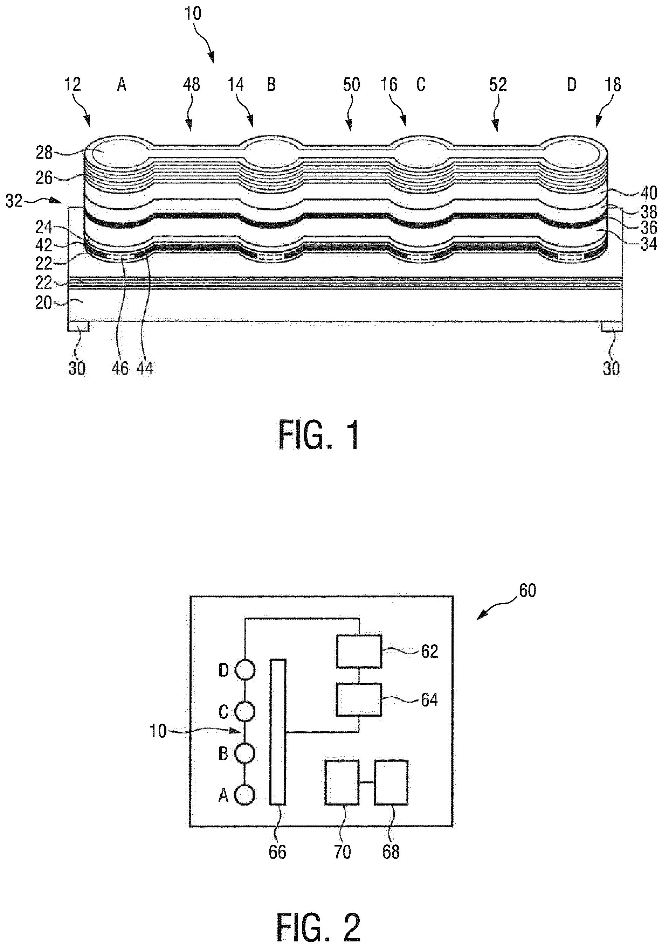

Fig. 1 shows a VCSEL device 10. The VCSEL device 10 comprises, as an example, an array of four VCSELs 12, 14, 16 and 18. The VCSELs 12, 14, 16, 18 are also denoted with A, B, C and D in the following. Each VCSEL may also be referred to as one mesa of the array. That is, the VCSELs 12, 14, 16, 18 form a one-dimensional array of mesas A, B, C, D. It is to be understood that the principles of the present invention may also be used in two-dimensional arrays of VCSELs, for example comprising an arrangement in which the VCSELs are arranged in rows and columns or in an arbitrary two-dimensional geometry. Further the number of VCSELs in the array may be different from four, e.g. two, three, or more than four.

Each VCSEL 12, 14, 16, 18 comprises a layer stack which will be described in the following. All layers to be described below are preferentially commonly shared by all VCSELs 12, 14, 16, 18. The term layer structure as used herein may include a single layer or a plurality of layers.

The layers of the layer stacks of the VCSELs 12, 14, 16, 18 are grown on a substrate 20. The substrate 20 may be a doped, e.g. n- or p-doped GaAs substrate, or an undoped GaAs substrate. A first distributed Bragg reflector (DBR) layer structure 22 is arranged on the substrate 20. The first DBR layer structure 22 may comprise n-doped AIGaAs/GaAs layer pairs, for example. Further as an example, the first DBR layer structure 22 may comprise 26 layer pairs. The first DBR layer structure may have a reflectivity of less than 99.9%, e.g. 99.87%.

Arranged on the first DBR layer structure 22 is an active region layer structure 24. The active region layer structure 24 may comprise one or more, e.g. three quantum wells for laser emission. The quantum wells may comprise InGaAs.

Each VCSEL 12, 14, 16, 18 further comprises a second DBR layer structure 26. The second DBR layer structure 26 may comprise p-doped AIGaAs/GaAs layer pairs. The number of layer pairs may be 29 as an example.

A first electrical contact 28 which may be a p-contact in this embodiment is arranged on top of the second DBR layer structure 26. The first electrical contact 28 may comprise a metal layer. The reflectivity of the second DBR layer structure 26 including the metal layer of the first electrical contact 28 may be 99.9%, for example.

The first DBR layer structure 22, the active region layer structure 24 and the second DBR layer structure 26 form an optical resonator for laser emission by the mesas A, B, C, D. In the present example, each VCSEL 12, 14, 16, 18 is a bottom emitter. However, it is to be understood that a VCSEL device according to the present invention may also be configured as a top emitter, wherein in the latter case, the first electrical contact 28 of each VCSEL 12, 14, 16, 18 may be configured as ring electrode so that light can emerge through the top side of the respective mesa A, B, C, D.

A second electrical contact 30, which may be an n-contact, is exemplarily indicated in Fig. 1 and may be arranged on the bottom of the substrate 20. In this case, the substrate 20 may be n-doped. Other positions of the contact 30 than positions on the substrate 20 are conceivable, for example on the lower DBR 22. In this case the substrate 20 may be undoped. The contact 30 may be configured such that it does not hinder light emission in case of a bottom emitting array.

Each VCSEL 12, 14, 16, 18 further comprises a phototransistor (PT) layer structure 32. The phototransistor layer structure may comprise a distributed heterojunction bipolar phototransistor (HPT) layer structure comprising a p-collector 34, a photosensitive region 36 comprising, for example, an absorptive quantum well, an n-base 38 and a p-emitter 40. The phototransistor 32 thus may have a pnp-structure. The phototransistor 32 is monolithically integrated in the optical resonator between the first and second DBR layer structures 22, 26.

The phototransistor layer structure 22 is arranged to provide an optical coupling between the active region layer structure 24 and the phototransistor layer structure 32 to provide an optically controlled or optically switched current aperture in the current path between the first electrical contact 28 and the second electrical contact 30 in each VCSEL 12, 14, 16, 18.

In addition to the optically controlled current aperture, there is provided a geometrically fixed current aperture in the current path between the first electrical contract 28 and the second electrical contact 30 in each of the VCSELs 12, 14, 16, 18. This geometrically fixed current aperture is provided by a current confinement layer structure 42. The current confinement layer structure 42 may comprise one or more layers with a current blocking region 44 and a current transmitting region 46 providing the current aperture. The current transmitting region 46 is indicated in Fig. 1 by broken lines as the current transmitting region or current aperture 46 is situated in the center of the current confinement layer structure of the respective VCSEL 12, 14, 16, 16 and thus cannot be seen in the perspective side view of Fig. 1. The current confinement layer structure 42 is arranged adjacent to the active region layer structure 24 in direction perpendicular to the plane of the active region layer structure 24. The current confinement layer structure 42 may be arranged or integrated in the first DBR layer structure 22 as shown in Fig. 1 or may be integrated or arranged in the second DBR layer structure 26 in other embodiments. Further, the current confinement layer structure 42 may be adjacent to the active region layer structure 24 in direction perpendicular to the plane of the phototransistor layer structure.

The substrate 20, the first DBR layer structure 22, the active region layer structure 24, the current confinement layer structure 42, the phototransistor layer structure 32, the second DBR layer structure 26 are layer structures which are commonly shared by the VCSELs 12, 14, 16 and 18. The first electrical contacts 28 of each of the VCSEL 12, 14, 16, 18 are connected in parallel. This may be achieved by providing the first electrical contacts 28 by a metal layer common to all VCSELs 12, 14, 16 and 18.

When manufacturing the VCSEL device 10, all the layer structures described above may be epitaxially grown onto the substrate 20. The layer stack such obtained may be then edged down to the first DBR layer structure 22 in order to obtain the mesas A, B, C and D, wherein neighboring mesas are connected by a ridge 48, 50 and 52, respectively. The ridges 48, 50, 52 comprise the same layer structure as the mesas A, B, C, D except that the ridges 48, 50, 52 comprise the blocking region 44 of the current confinement layer structure 42 only. Thus, each VCSEL 12, 14, 16, 18 defines a single light emission region of the array, and adjacent light emission regions are connected by a ridge 48, 50, 52 also comprising the commonly shared layer structure. The ridges 48, 50, 52 comprise the current blocking regions 44 of the current confinement layer structure 42 only.

Fig. 2 shows a laser light source 60 comprising the VCSEL device 10. The laser light source 60 further comprises a power source 62 as a drive current supply. The power source 62 is arranged to supply a drive current to the VCSELs A, B, C and D. The VCSELs A, B, C and D are driven in parallel. The power source 62 may be connected to one of the VCSELs A, B, C, D only, as shown to the VCSEL D into which the drive current is injected. Since the first contacts 28 of the VCSELs A, B, C and D are electrically connected in parallel, the VCSELs are driven in parallel. Current injection, however, can also be made into one of the other VCSELs A, B, C. In the present embodiment, current is preferentially injected into a VCSEL which is arranged at an end of the array.

The laser light source 60 further comprises a drive current control 64 which is arranged to control the power source 62. The drive current control 64 is arranged to cause the power source 62 to increase or to lower the current supply to the VCSELs or even to interrupt the current supply based on a signal from a laser emission output detector 66 which is arranged to detect whether or not the array of the VCSELs A, B, C and D outputs laser radiation. The emission output detector 66 may be configured as a photodetector, e.g. a photodiode. Such a photodiode may be integrated into the layer stack of the VCSELs A, B, C and D, or may be an external photodetector arranged such that it can detect laser output emission of any of the VCSELs A, B, C and D. The laser emission output detector 66 may also be configured as a voltage detector which may detect a voltage increase when none of the VCSLs A, B, C and D outputs laser emission.

Before the operation of the VCSEL device 10 and the laser light source 60 will be described, the operation of a VCSEL array with oxide aperture in each of the VCSELs, but without integrated phototransistors, and the operation of a VCSEL array comprising VCSELs with phototransistor, but without oxide apertures will be discussed.

In an array of parallel-driven VCSELs each having an oxide aperture but no phototransistor, all VCSELs in the array would emit laser radiation at the same time when a driving current is supplied. This behavior provides high optical output powers, but in case of a defect of a VCSEL in the array, there is no possibility to replace the defect VCSEL without complicated repair. Assuming an array with two VCSELs, and when one VCSEL breaks down, the current concentrates on the other VCSEL, leading to an increased output power of that VCSEL, while thermal effects (like non-radiating recombination) will reduce the output power again and decreases the life-time of that VCSEL. This behavior is disadvantageous in applications where a constant output power of the array is required.

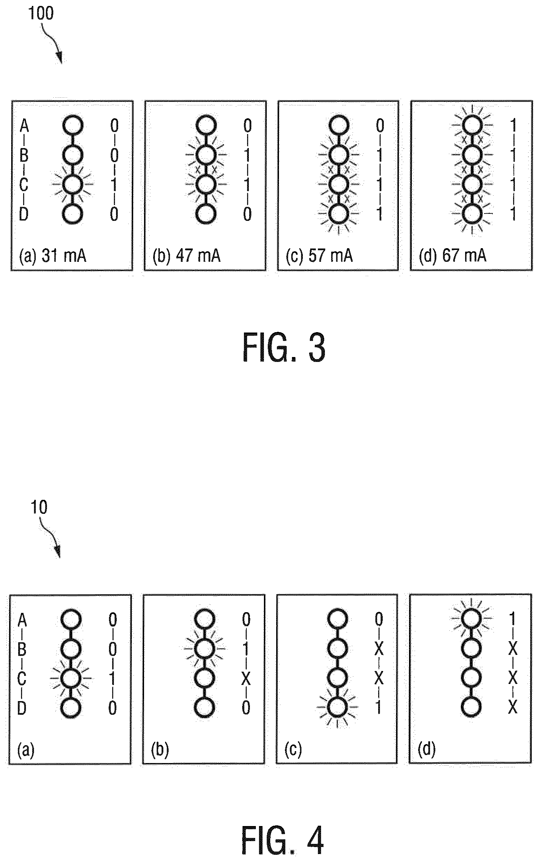

An array of VCSELs with integrated phototransistors, but without additional geometrically fixed current aperture, has specific switching-on characteristics which will be described with reference to Fig. 3. Fig. 3 shows a VCSEL device 100 comprising an array of VCSELs A, B, C, D, wherein each VCSEL has an integrated phototransistor, but no geometrically fixed current aperture. The VCSELs A, B, C and D are again driven in parallel.

Upon increasing the drive current, the switching-on characteristics of the VCSEL device 100 are determined by optical effects on the one hand and by lateral ohmic losses on the other hand. Assuming that the VCSEL device 100 is electrically contacted at the VCSEL D with the power source, the electrical losses increase from the VCSEL D to the VCSEL A. Then it is a matter of the imbalance between optical and electrical influences which determines the switching-on sequence. The optical influences arise from a superimposition of intensities of spontaneous photons within the resonators of the single VCSELs. For low lateral ohmic losses, a central VCSEL always switches on first since the optical intensity distribution initially is highest in the center of the array. This is shown in Fig. 3a), where VCSEL C switches on first (denoted by '1' for VCSEL C and '0' for the other VCSELs A, B and D), when the drive current reaches for example 31 mA. With identical optical intensity in a symmetric array then the lateral ohmic losses decide on further formations of current apertures. However, in a normal array-design where the single VCSELs are connected by ridges, also the areas below the ridges become successively conductive so that finally a comparatively large current aperture is generated with the effect that the laser threshold cannot be reached anymore. If the drive current is increased to 47 mA, VCSEL B switches on in addition to VCSEL C. When the drive current is increased further, e.g. to 57 mA now three VCSELs C, B, D are switched on, as shown in Fig. 3c). Finally, if the drive current is increased further to 67 mA, all VCSELs A, B, C and D are switched on as shown in Fig. 3d). This behavior is not desired as well, in terms of power consumption due to high laser thresholds as well as in terms of constant output power and life-time.

The effect of a successively increasing current aperture through the array is avoided with the VCSEL device 10 in Fig. 1 in which each VCSEL A, B, C and D comprises a combination of an integrated phototransistor and a geometrically fixed current aperture provided by the current confinement layer structure 42 which provides a geometrically fixed current aperture in addition to the optically controlled current aperture provided by the phototransistor. The geometrically fixed current aperture prevents a spreading of the current before the optically controlled current aperture provided by the phototransistors opens. Thus, the actual current confinement is significantly influenced by the geometrically fixed current aperture provided by the current confinement layer, and the phototransistor decides on the point of time of switching on.

Fig. 4 shows the switching-on behavior of the VCSEL device 10 when the power source 62 (Fig. 2) is connected to the VCSEL D, wherein the VCSELs A to D are driven in parallel. Via the leakage current of the phototransistor spontaneous photons are generated in the active region 24 which provide for a base current which in turn provides for the opening of the optical switch provided by the phototransistor. Like in Fig. 3a), the VCSEL C switches on first (denoted by '1), while the other VCSELs A, B and D remain inactive (denoted by '0'). However, differently from the situation in Fig. 3a), the threshold current is decreased drastically due to the smaller current aperture provided by the current confinement layer structure 42. In order that two or more VCSELs will lase simultaneously, much higher drive currents would be required in comparison with the situation in Fig. 3. When the laser emission of the VCSEL C breaks down (denoted by 'X'), e.g. when the VCSEL C is consumed or becomes defect, then an other VCSEL, here the VCSEL B switches on, while the other VCSELs A and D remain inactive. When laser emission by the VCSEL B breaks down, e.g. because the VCSEL B is consumed or becomes defect, then the VCSEL D becomes active, and after break down of the laser emission of the VCSEL D the VCSEL A becomes active. Thus, at the same time, only one of the VCSELs A, B, C and D actively emits laser radiation. The laser threshold is more or less the same in Fig. 4a to Fig. 4d, differently from the situation shown in Fig. 3a to 3d.

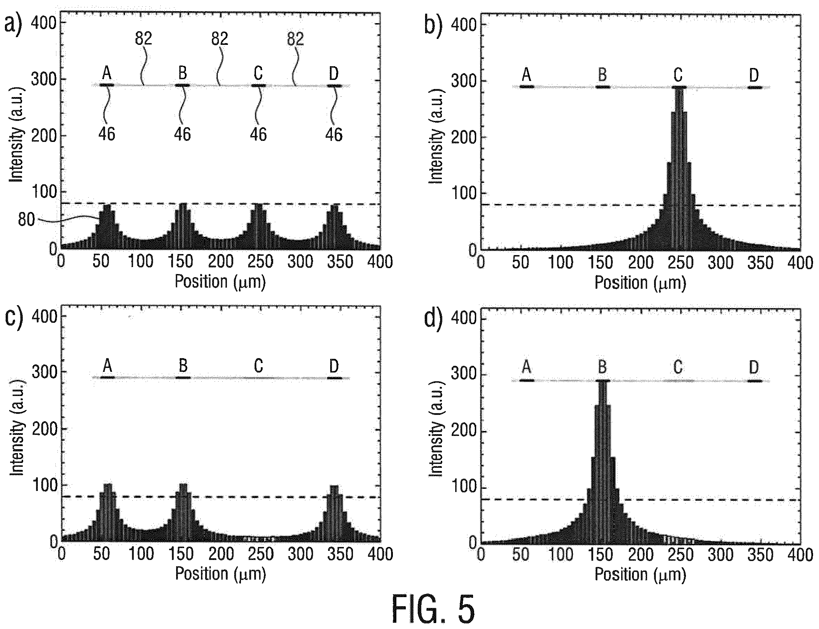

Fig. 5 shows diagrams of simulations confirming the switching-on behavior of the VCSEL device 10 as shown in Fig. 4. In each diagram of Fig. 5a) to d), the current aperture of each of the VCSELs A, B, C and D is illustrated by a short line 46. The abscissae axis in each diagram gives the position of the single VCSELs in the array, and the ordinate axis gives the optical intensity indicated by a bar diagram 80 within the VCSEL array along the positions A to D. The VCSELs A, B, C and D are driven in parallel indicated by a line 82 indicating for example the metal layer forming the first electrical contacts 28 of the VCSELs. The drive current is again injected into the first electrical contact 28 of the VCSEL D in this simulation.

Starting from Fig. 5a), when the drive current is switched on, spontaneous photons are emitted leading to an optical intensity distribution in the array as shown by the bar diagram 80 in Fig. 5a). When increasing the drive current, the PT of the VCSEL C opens first and the VCSEL C is activated first to emit laser light as shown in Fig. 5b). The current immediately concentrates on the VCSEL C leading to an increase of the optical intensity and neglects (except leakage currents) the other VCSELs A, B and D. However, differently from the situation explained with respect to Fig. 3a), the current aperture has simultaneously reduced from 100 µm to 20 µm (for a simulated geometrically fixed current aperture of 15 µm provided by the current confinement layer). Also the drive current for reaching this state was increased to the sixfold value. This shall - in the ideal case - lead to an immediate transition of the VCSEL C into stimulated emission, i.e. laser light emission. In comparison with the VCSEL device 100 in which the VCSELs have integrated phototransistors, but no geometrically fixed current apertures, at least 2.5-times higher drive currents may be injected without activating more than one VCSEL in the array. Thus, the current aperture also becomes geometrically more stable. Upon a simulated break down the drive current diverts initially to the remaining three VCSELs A, B and D as shown in Fig. 5c). By a short reduction or interruption of the drive current supply by the power source 62 to the VCSEL array and a subsequent increase of the drive current, only the VCSEL B will be switched on.

The selectivity to activate only one VCSEL after the breakdown of a previously active VCSEL is only or at least mainly determined by the influence of the phototransistor, while the small current aperture and the low laser thresholds resulting from the small current apertures are achieved by the hybrid design which includes the additional current confinement layer structure providing geometrically fixed current apertures and keep the areas below the ridges between the mesas non-conducting. After the breakdown of the VCSEL B, the VCSEL D, and after breakdown of the VCSEL D, finally the VCSEL A will be activated as shown in Fig. 4c and d (not shown in Fig. 5). After all VCSELs are consumed, the VCSEL device 10 has reached its maximum life-time. There is always only one VCSEL in the array which emits laser light at the same time.

In the simulation according to Fig. 5, the following exemplary parameters have been assumed. The diameter of each VCSEL A, B, C, D (mesa) is 35 µm, the length of the ridges 48, 50, 52 is 60 µm. Deviations from these parameters are possible, which will, however influence the order of the switching on of a subsequent VCSEL after breakdown of an active VCSEL. Larger ridge lengths lead to stronger lateral ohmic losses, but also to a reduction of the optical influence of the VCSELs on each other. This may be desired, since upon increasing the drive current (and the simultaneous increase of the internal optical intensity in the array), an activation of the optical switches (phototransistors) of the neighboring VCSELs may be avoided. Further, lateral losses may be varied by the doping of the first and second DBR layer structures 22 and 26, for example. Extremely high losses provide for a changed operational behavior of the array in case of a defect. In case of extremely high losses through the array, the VCSEL which is positioned closest to the electrical injection point is activated first, and after the breakdown of this VCSEL, the neighboring is activated, thus leading to a switching on sequence D-C-B-A, if current is injected into the VCSEL D. In this case, the electrical influences dominate over the optical influences, however the high optical losses have an effect on the optical output power of VCSELs remote to the injection point, if the drive current is not adapted.

As described above, the power source 62 of the laser light source 60 is configured to reduce or interrupt the drive current to the VCSEL device 10 upon a breakdown of the active VCSEL which may be detected by the detector 66. The drive current supply may be interrupted for a short time period only and then increased again.

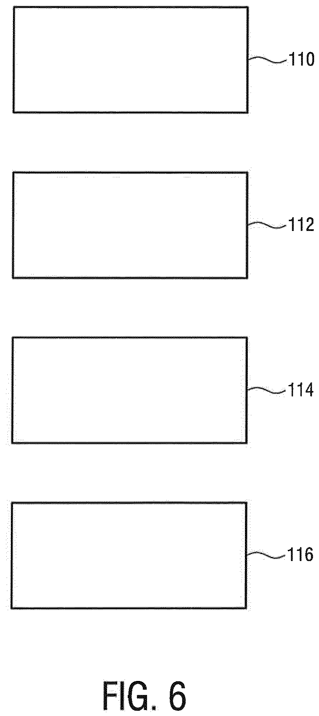

Fig. 6 shows a method of operating the laser light source 60. The method comprises at 110 providing a drive current to the array of VCSELs 12, 14, 16, 18 of the VCSEL device 10.

At 112, the drive current is increased such that only one of the VCSELs of the array emits laser light and all other VCSELs of the array do not emit laser light.

At 114, the laser emission is monitored by means of the detector 66.

At 116, the drive current is decreased or interrupted when the monitoring at 114 reveals a breakdown of the laser emission of the VCSEL device 10, and then increased so that an other VCSEL of the array emits laser light, and all other VCSELs of the array do not emit laser light.

The method may be configured as a computer program which may be stored in a memory 68 of the laser light source 60. The laser light source 60 may comprise a processor 70 on which the computer program is carried out. The computer program may also be stored/distributed on a suitable non-transitory medium, such as an optical storage medium or a solid-state medium supplied together with or as part of the laser light source or of the VCSEL device 10, but may also be distributed in other forms, such as via the Internet or other wired or wireless telecommunication systems.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single element or other unit may fulfill the functions of several items recited in the claims. The mere fact that certain measures are recited in mutually different dependent claims does not indicate that a combination of these measures cannot be used to advantage.

Any reference signs in the claims should not be construed as limiting the scope.

## Claims

1. Vertical Cavity Surface Emitting Laser device, comprising:
a one- or two-dimensional array of Vertical Cavity Surface Emitting Lasers (12, 14, 16, 18), each of the Vertical Cavity Surface Emitting Lasers (12, 14, 16, 18) comprising:
a first distributed Bragg reflector layer structure (22), a second distributed Bragg reflector layer structure (26) and an active region layer structure (24) arranged between the first and second distributed Bragg reflector layer structures (22, 26) for laser emission,
a first electrical contact (28) and a second electrical contact (30) arranged to provide a current path between the first and second electrical contacts (28, 30) to provide a drive current to the active region layer structure (24),
a phototransistor layer structure (32), wherein the phototransistor layer structure (32) is arranged such that there is an optical coupling between the active region layer structure (24) and the phototransistor layer structure (32) to provide an optically controlled first current aperture in the current path during operation of the Vertical Cavity Surface Emitting Laser (12, 14, 16, 18),
a current confinement layer structure (42) configured to provide a geometrically fixed second current aperture (46) in the current path in addition to the optically controlled first current aperture,
wherein the first electrical contacts (28) of the Vertical Cavity Surface Emitting Lasers (12, 14, 16, 18) are electrically connected in parallel.

2. Vertical Cavity Surface Emitting Laser device of any of claim 1, wherein at least one of the first distributed Bragg reflector layer structure (22), the second distributed Bragg reflector layer structure (26), the active region layer structure (24), the phototransistor layer structure (32), or the current confinement layer structure (42) is a layer structure commonly shared by the Vertical Cavity Surface Emitting Lasers (12, 14, 16, 18) of the array.

3. Vertical Cavity Surface Emitting Laser device of claim 2, wherein each Vertical Cavity Surface Emitting Laser (12, 14, 16, 18) defines a light emission region of the array, and adjacent light emission regions are connected by a ridge (48, 50, 52) comprising the at least one commonly shared layer structure.

4. Vertical Cavity Surface Emitting Laser device of any of claims 1 to 3, wherein the phototransistor layer structure (32) is a distributed bipolar phototransistor layer structure.

5. Vertical Cavity Surface Emitting Laser device of any of claims 1 to 4, wherein the current confinement layer structure (42) comprises a current-blocking region (44) and a current transmitting region to provide the second current aperture (46).

6. Vertical Cavity Surface Emitting Laser device of any of claims 1 to 5, wherein the phototransistor layer structure (32) and the current confinement layer structure (42) are arranged adjacent to one another in direction perpendicular to a plane of the layer structures (32, 42).

7. Vertical Cavity Surface Emitting Laser device of any of claims 1 to 6, wherein the phototransistor layer structure (32) or the current confinement layer structure (42) is arranged adjacent to the active region layer structure (24) in direction perpendicular to a plane of the layer structures (32, 42, 24).

8. Laser light source, comprising a Vertical Cavity Surface Emitting Laser device (10) according to any of claims 1 to 7 and a power source (62) to supply a drive current to the array of Vertical Cavity Surface Emitting Lasers (12, 14, 16, 18).

9. Laser light source of claim 8, further comprising a drive current control (64) configured to reduce or interrupt the drive current supply to the array upon a breakdown of laser emission of the array and then to increase the drive current again.

10. Laser light source of claim 9, further comprising a laser emission output detector (66) configured to detect the breakdown of laser emission of the array.

11. Laser light source of any of claims 8 to 10, wherein the power source (62) is electrically connected to one of the first contacts (28) to inject drive current into said one of the first contacts (28).

12. Laser light source of claim 11, wherein said one of the first contacts (28) is a contact of a Vertical Cavity Surface Emitting Laser (18) arranged at a lateral end of the array.

13. Method of operating a laser light source according to any of claims 8 to 12, comprising:
providing a drive current to the array of Vertical Cavity Surface Emitting Lasers (12, 14, 16, 18),
increasing the drive current such that only one (16) of the Vertical Cavity Surface Emitting Lasers (12, 14, 16, 18) of the array emits laser light and all other Vertical Cavity Surface Emitting Lasers (12, 14, 18) of the array do not emit laser light, and
monitoring the laser emission.

14. Method of claim 13, further comprising:
decreasing the drive current when the monitoring reveals a breakdown of the laser emission,
increasing again the drive current, until an other Vertical Cavity Surface Emitting Laser (14) of the array emits laser light, and all other Vertical Cavity Surface Emitting Lasers (12, 16, 18) of the array do not emit laser light.

15. Computer program comprising program code means for causing a laser light source (60) to carry out the steps of the method as claimed in claim 13 or 14, when said computer program is carried out on a processor of the laser light source (60).
